# EUROPÄISCHE PATENTANMELDUNG

(11) **EP 1 286 454 A2**
(43) Veröffentlichungstag der Anmeldung: **26.02.2003**
(21) Anmeldenummer: 02011388.2
(22) Anmeldetag: 24.05.2002
(51) Int. Cl.: H02M 3/158

(54) **Schaltregler und diesen verwendender Verstärker**

(30) Priorität: 30.05.2001 DE 10126236
(71) Anmelder: Harman/Becker Automotive Systems (Becker Division) GmbH, 76307 Karlsbad (DE)
(72) Erfinder: Jurzitza, Dieter, Dr. Ing., 76131 Karlsruhe (DE)
(74) Vertreter: Patentanwälte Westphal, Mussgnug & Partner

(57) **Zusammenfassung**

Ein Schaltregler umfasst einen Versorgungsspannungsanschluss (IN), einen Masseanschluss (OUT), ein induktives Element (L), von dem eine erste Klemme über einen ersten Schalter (T1) mit dem Versorgungsspannungsanschluss (IN) verbindbar ist, ein kapazitives Element (C), von dem eine erste Klemme mit einer zweiten Klemme des induktiven Elements (L) und eine zweite Klemme mit dem Masseanschluss (GND) verbunden ist, und einen Ausgangsanschluss (OUT) zum Ausgeben einer Ausgangsspannung, der mit der ersten Klemme des kapazitiven Elements (C) verbunden ist. Ein zweiter Schalter (T4) ist parallel zu dem kapazitiven Element (C) angeordnet. Der Schaltregler ist geeignet zum Aufbau eines Verstärkers für ein Audiosignal.

## Beschreibung

Die vorliegende Erfindung betrifft einen Schaltregler und dessen Anwendung in einem Verstärker, insbesondere einem Verstärker für Audiosignale.

Es sind diverse Typen von Schaltreglern bekannt, die sich in ihrer Schaltungsanordnung unterscheiden, je nach dem, ob sie zum Liefern einer Ausgangsspannung mit zu einer Versorgungsspannung entgegengesetztem Vorzeichen, einer Ausgangsspannung zwischen 0 und der Versorgungsspannung oder einer Ausgangsspannung oberhalb der Versorgungsspannung vorgesehen sind. Alle diese Schaltregler weisen ein aus einem induktiven Element und einem kapazitiven Element gebildetes LC-Glied und wenigstens einen Schalter auf, der durch alternierendes Öffnen und Schließen die Speicherung über den Versorgungsspannungsanschluß zugeführter elektrischer Energie in dem LC-Glied und die Abgabe der gespeicherten Energie auf einem anderen Spannungspegel am Ausgangsanschluß ermöglicht. Die Grundprinzipien derartiger Schaltregler sind bei Tietze-Schenk, Halbleiterschaltungstechnik, 11. Auflage, Springer-Verlag, Berlin, 1999, Seiten 979 ff. beschrieben.

Ein Nachteil dieser bekannten Schaltregler ist, daß sie jeweils nur für einen begrenzten Ausgangsspannungsbereich brauchbar sind. Um einen Schaltregler zu bauen, der Ausgangsspannungen oberhalb und unterhalb einer Versorgungsspannung liefern kann, müssen zwei dieser bekannten Schaltregler, einer von dem als Aufwärtsregler oder Hochsetzsteller bekannten Typ, und einer von dem als Abwärtsregler oder Tiefsetzsteller bekannten Typ, parallel vorgesehen werden und je nach benötigter Ausgangsspannung im Wechsel betrieben werden. Dies erfordert nicht nur einen hohen Schaltungsaufwand für die Schaltregler als solche, auch ihre Ansteuerung ist kompliziert, da je nach dem, ob Ausgangsspannungen oberhalb oder unterhalb der Versorgungsspannung zu liefern sind, unterschiedliche Schalter mit unterschiedlichen Gesetzmäßigkeiten des Zusammenhanges zwischen Schalter-Tastverhältnis und erzeugter Ausgangsspannung angesteuert werden müssen.

Eine Aufgabe der vorliegenden Erfindung ist, einen Schaltregler anzugeben, der es ermöglicht, mit einer einfachen Ansteuerung, die keine Fallunterscheidung zwischen Ausgangsspannungen oberhalb und unterhalb der Versorgungsspannung erfordert, Ausgangsspannungen in einem Intervall beiderseits des Versorgungsspannungspegels zu erzeugen.

Diese Aufgabe wird erfindungsgemäß gelöst durch einen Schaltregler mit einem Versorgungsspannungsanschluß, einem Masseanschluß, einem induktiven Element, von dem eine erste Klemme über einen ersten Schalter mit dem Versorgungsspannungsanschluß verbindbar ist, einem kapazitiven Element, von dem eine erste Klemme mit einer zweiten Klemme des induktiven Elementes und eine zweite Klemme mit dem Masseanschluß verbunden ist, und einem Ausgangsanschluß zum Ausgeben einer Ausgangsspannung, der mit der ersten Klemme des kapazitiven Elementes verbunden ist, wobei der Schaltregler dadurch gekennzeichnet ist, daß ein zweiter Schalter parallel zu dem kapazitiven Element angeordnet ist.

Diese Schaltungsanordnung erlaubt es, in einer ersten Phase des Betriebes des Schaltreglers, in der zwei Schalter geschlossen sind, einen Strom vom Versorgungsspannungsanschluß über das induktive Element unter Umgehung des kapazitiven Elementes direkt nach Masse zu leiten, und so eine zum Quadrat der momentanen Stromstärke im induktiven Element proportionale Energie in diesem zu speichern, um dann in einer zweiten Phase des Betriebes, in der die Schalter geschlossen sind, die in dem induktiven Element gespeicherte Energie geglättet durch das kapazitive Element am Ausgangsanschluß auszugeben.

Vorzugsweise ist in einer bestimmten Schaltstellung der Schalter eine Diode bezogen auf die Versorgungsspannung in Sperr-Richtung parallel zu der Reihenschaltung von induktivem und kapazitivem Element angeordnet. Diese Diode sperrt, so lange die Schalter geöffnet sind, wird aber beim Schließen der Schalter für den von dem induktiven Element erzeugten Strom durchlässig.

Durch phasengleiches Öffnen und Schließen der zwei Schalter wird eine Ausgangsspannung erzeugt, die allein in Abhängigkeit von dem gemeinsamen Tastverhältnis der zwei Schalter Werte zwischen 0 und einem gewissen Grenzwert annehmen kann, der oberhalb der Versorgungsspannung liegt.

Wenn eine Ausgangsspannung deutlich oberhalb der Versorgungsspannung mit hoher Ausgangsleistung benötigt wird, so besteht zusätzlich die Möglichkeit, anstelle einer gleichphasigen Ansteuerung der zwei Schalter den ersten Schalter dauerhaft geöffnet zu halten und nur den zweiten mit einem bestimmten Tastverhältnis zu öffnen und zu schließen. Bei dieser Art der Ansteuerung wird der Stromfluss vom Versorgungsspannungsanschluss in das induktive Element niemals unterbrochen, so dass im Mittel ein höherer Strom im induktiven Element fließen kann als bei alternierendem Betrieb beider Schalter. Dieser höhere Strom entspricht einer größeren im induktiven Element gespeicherten Energiemenge und damit einer größeren am Ausgangsanschluss bei gegebener Ausgangsspannung abgreifbaren Leistung. Dadurch verkompliziert sich zwar die Ansteuerung, dies kann aber aufgrund der verbesserten Ausgangsleistung gern in Kauf genommen werden.

Wenn eine Ausgangsspannung deutlich unterhalb der Versorgungsspannung mit hoher Ausgangsleistung benötigt wird, so besteht zusätzlich die Möglichkeit, anstelle einer gleichphasigen Ansteuerung der zwei Schalter den zweiten Schalter dauerhaft geöffnet zu halten und nur den ersten mit einem bestimmten Tastverhältnis zu öffnen und zu schließen. Bei dieser Art der Ansteuerung wird ein Abfließen des durch das induktive Element fließenden Stroms über den zweiten Schalter gegen Masse unterbunden, und der gesamte Stromfluss vom Versorgungsspannungsanschluss wird durch den Verbraucher R_{LAST} gezwungen.

Eine Ansteuerschaltung zum Ansteuern der Schalter des Schaltreglers ist vorzugsweise in diesem enthalten.

Vorzugsweise umfaßt der Schaltregler ferner noch einen vierten Schalter zum Unterbrechen der Verbindung zwischen der zweiten Klemme des induktiven Elements und der ersten Klemme des kapazitiven Elementes und eine zweite Diode, die bezogen auf die Versorgungsspannung in Sperr-Richtung gepolt die ersten Klemmen des induktiven und des kapazitiven Elementes verbindet. So lange dieser vierte Schalter ständig geschlossen ist, liefert der Schaltregler eine Ausgangsspannung mit dem Vorzeichen der Versorgungsspannung.

Ist der vierte Schalter jedoch ständig geöffnet, so bewirkt ein alternierendes Öffnen und Schließen des ersten Schalters einen Betrieb des Schaltreglers als Inverter.

Ein fünfter Schalter ist zweckmäßigerweise in Reihe mit der zweiten Diode zwischen den ersten Klemmen des induktiven und des kapazitiven Elementes angeordnet. Dieser Schalter wird beim Betrieb des Schaltreglers zum Erzeugen einer Ausgangsspannung mit dem Vorzeichen der Versorgungsspannung geöffnet gehalten, um zu verhindern, daß der vom induktiven Element gelieferte Ausgangsstrom über die zweite Diode anstatt über den Verbraucher R_{LAST} fließt. Beim Inverterbetrieb ist der fünfte Schalter offen.

Eine bevorzugte Anwendung des erfindungsgemäßen Schaltreglers ist ein Verstärker, insbesondere ein Verstärker für ein niederfrequentes Signal wie etwa ein Audiosignal, bei dem die Ausgangsspannung des Schaltreglers in Abhängigkeit von dem Momentanwert des Audiosignals geregelt wird und das Ausgangssignal des Verstärkers von der Ausgangsspannung des Schaltreglers abgeleitet ist.

Ein solcher Verstärker ist zweckmäßigerweise mit einem Komparator zum Vergleichen der Ausgangsspannung des Schaltreglers mit einer als Funktion des Verstärkereingangssignals vorgegebenen Spannung ausgestattet. Ein solcher Komparator ermöglicht die Erzeugung der Ausgangsspannung mit einem hohen Maß an Linearität.

Um eine in der Ausgangsspannung des Schaltreglers durch dessen Schaltbetrieb normalerweise enthaltene Restwelligkeit in dem verstärkten Signal zu untterdrücken, ist zwischen dem Ausgangsanschluß des Schaltreglers und dem Ausgang des Verstärkers zweckmäßigerweise ein Tiefpaßfilter angeordnet. Die Grenzfrequenz eines solchen Filters liegt zwischen der oberen Grenzfrequenz des zu verstärkenden Signals und der Tastfrequenz, mit der die Schalter jeweils ein- und ausgeschaltet werden.

Weitere Merkmale und Vorteile der Erfindung ergeben sich aus der nachfolgenden Beschreibung von Ausführungsbeispielen mit Bezug auf die beigefügten Figuren. Es zeigen:
Figur 1 eine einfache Ausgestaltung eines erfindungsgemäßen Schaltreglers, der zur Erzeugung von Ausgangsspannungen sowohl oberhalb als auch unterhalb der Versorgungsspannung geeignet ist;
Figur 2 eine Weiterentwicklung des Schaltreglers aus Figur 1, die in der Lage ist, bipolare Ausgangsspannungen zu liefern;
Figur 3 eine vereinfachte Darstellung des Schaltreglers aus Figur 2, in der nur diejenigen Schaltungskomponenten gezeigt sind, die am Inverterbetrieb des Schaltreglers beteiligt sind;
Figur 4 den zeitlichen Verlauf der Ansteuersignale der diversen Schalter beim Betrieb des Schaltreglers aus Figur 2 als Hochsetzsteller, Tiefsetzsteller, in einem dazwischenliegenden Betriebszustand und als Inverter;
Figur 5 ein Blockdiagramm eines Audioverstärkersystems, das einen erfindungsgemäßen Schaltregler verwendet; und
Fig. 6 Varianten der Ansteuerung von Transistoren in der Schaltung der Fig. 1 oder 2.

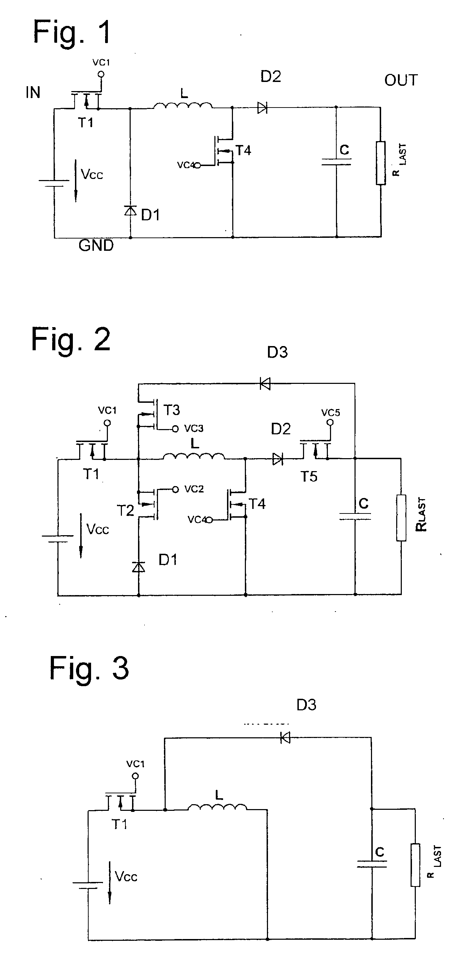

Figur 1 zeigt ein schematisches Schaltbild einer ersten, einfachen Ausgestaltung des erfindungsgemäßen Schaltreglers. Ein erster Schalter in Form eines Feldeffekttransistors T1 ist zwischen einem Versorgungsspannungsanschluß IN und einer ersten Klemme einer Spule L angeordnet. Er wird von einer (nicht dargestellten) Ansteuervorrichtung mit einer Steuerspannung VC1 versorgt. Eine erste Diode D1 ist einerseits mit der ersten Klemme der Spule L und andererseits mit einem Masseanschluß GND in einer solchen Orientierung verbunden, daß sie einen durch den Schalter T1 fließenden Versorgungsstrom sperrt.

Eine zweite Klemme der Spule L ist über eine in Durchgangsrichtung orientierte zweite Diode D2 mit der ersten Klemme eines Kondensators C verbunden, dessen zweite Klemme ebenfalls am Masseanschluß GND liegt. Ein zweiter Schalter T4, der von der Ansteuerschaltung mit einer Steuerspannung VC4 versorgt wird, ist zwischen der zweiten Klemme der Spule L und dem Masseanschluß angeordnet.

Ein zwischen dem Ausgangsanschluß OUT und Masse angeordneter Lastwiderstand R_{LAST} stellt einen Verbraucher dar, der von dem Schaltregler versorgt wird.

Die zwei Feldeffekttransistoren T1, T4 werden von der Ansteuerschaltung mit Hilfe der Steuerspannungen VC1, VC4 jeweils phasengleich ein- und ausgeschaltet. Sind beide Transistoren gleichzeitig leitend, so baut sich ein Stromfluß vom Versorgungsspannungsanschluß IN über den Transistor T1, die Spule L und den Transistor T4 gegen Masse auf. Werden beide Transistoren T1, T4 gleichzeitig hochohmig geschaltet, so ist in der Spule L eine Energiemenge 0,5 x L x I² gespeichert, wobei L die Induktivität der Spule und I die Stromstärke in der Spule im Moment des Hochohmigschaltens der Transistoren bezeichnet. Diese Energiemenge führt dazu, daß nun eine nicht vernachlässigbare Spannung an der zweiten Klemme der Spule L aufgebaut wird, die über die Diode D2 und geglättet durch den Kondensator C durch den Verbraucher R_{LAST} gegen Masse fließt.

In dem Grenzfall, daß die Tastverhältnisse beider Transistoren T1, T4 gegen 0 gehen, kann die Spannung am Ausgangsanschluß OUT Werte beliebig nahe bei 0 annehmen.

Um sich das Verhalten der Schaltung im anderen Grenzfall, daß beide Tastverhältnisse gegen 1 gehen, anschaulich zu machen, kann man den Fall betrachten, daß das Tastverhältnis des Transistors T1 exakt 1 beträgt, das des Transistors T4 aber 1-ε, wobei ε eine kleine reelle Zahl ist. In diesem Fall verhält sich die Schaltung der Figur 1 wie ein herkömmlicher Hochsetzsteller mit einem Tastverhältnis von 1-ε: dieser liefert eine Ausgangsspannung, die wesentlich höher als die Versorgungsspannung ist. Wie man daran sieht, erlaubt die Schaltung der Figur 1 allein durch Variieren der untereinander gleichen, gemeinsam aber durch die Ansteuerschaltun variabel vorgebbaren Tastverhältnisse der Transistoren T1, T4 die Erzeugung von Ausgangsspannungen im Bereich von 0 bis zu einem oberen Grenzwert, der durch die intrinsischen Widerstände der Schaltungselemente bestimmt ist.

Figur 2 zeigt eine Weiterentwicklung des Schaltreglers aus Figur 1, die durch eine Reihe zusätzlicher Schaltungskomponenten ergänzt ist. Komponenten, die bereits in der Schaltung der Figur 1 enthalten waren, tragen gleiche Bezugszeichen und werden nicht erneut beschrieben. Zu den zusätzlichen Komponenten gehört ein Feldeffekttransistor T2, der in Reihe mit der Diode D1 zwischen die erste Klemme der Spule L und Masse geschaltet ist, ein Feldeffekttransistor T5, der in Reihe mit der Diode D2 zwischen der zweiten Klemme der Spule L und der ersten Klemme des Kondensators C angeordnet ist, sowie eine Reihenschaltung aus einem Feldeffekttransistor T3 und einer Diode D3, die die erste Klemme der Spule L1 mit der ersten Klemme des Kondensators C verbindet.

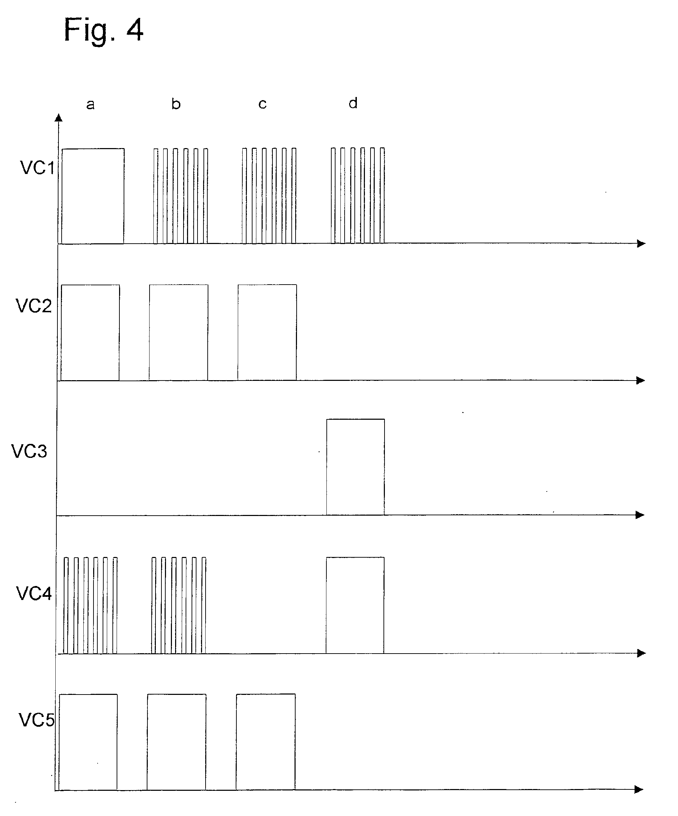

Figur 4 zeigt den zeitlichen Verlauf von Steuerspannungen VC1 bis VC5, die von der Ansteuerschaltung in Abhängigkeit von einer zu erzeugenden Ausgangsspannung den Transistoren T1 bis T5 zugeführt werden.

In einem ersten Betriebsmodus der Schaltung der Figur 2, dargestellt als Spalte a von Figur 4, sind die Transistoren T1, T2, T5 durch die Steuerspannungen VC1, VC2, VC5 niederohmig geschaltet, der Transistor T3 ist hochohmig, und der Transistor T4 wird alternierend betrieben. Ein solches Muster der Ansteuerung der Transistoren entspricht dem Betrieb des Schaltreglers als reiner Hochsetzsteller, der in der Lage ist, je nach Tastverhältnis, mit dem der Transistor T4 umgeschaltet wird, Spannungen zwischen der Versorgungsspannung VCC und einer oberen Grenzspannung zu liefern.

Im Modus der Spalte b werden die Transistoren T1, T4 alternierend betrieben, während die Transistoren T2, T5 neiderohmig sind und T3 sperrt. Dieser Betriebsmodus entspricht dem oben mit Bezug auf Figur 1 beschriebenen.

In einem dritten Modus, dargestellt als Spalte c, wird T1 alternierend betrieben, T2 und T5 sind niederohmig und T3 und T4 sind hochohmig. Dies entspricht dem Betrieb der Schaltung als Tiefsetzsteller, der in der Lage ist, Ausgangsspannungen zwischen 0 und der Versorgungsspannung zu liefern.

In einem vierten Modus, dargestellt als Spalte d in Figur 4, wird der Transistor T1 alternierend betrieben, die Transistoren T3, T4 sind niederohmig, und die Transistoren T2, T5 sind hochohmig.

Figur 3 zeigt eine vereinfachte Darstellung der Schaltung aus Figur 2, bei der alle Verbindungen, die in diesem vierten Modus einen hochohmigen Transistor enthalten, weggelassen sind, und der dauerhaft niederohmige Transistor T4 durch eine durchgezogene Linie ersetzt ist. Wenn bei dieser Schaltung der Transistor T1 offen ist, wird ein Strom durch die Spule L aufgebaut, der beim Schließen des Transistors T1 zu einem Spannungsabfall auf negative Werte an der mit dem Transistor T1 verbundenen ersten Klemme der Spule L1 führt. Dieser Spannungsabfall wird über die dann durchlässige Diode D3 an den Ausgangsanschluß OUT weitergegeben. Das heißt, im Modus der Spalte d zeigt die Schaltung das Verhalten eines Inverters.

Die Schaltung der Figur 2 ist also in der Lage, je nach Ansteuerung der diversen Transistoren sowohl positive als auch negative Ausgangsspannungen zu erzeugen, deren Betrag den der Versorgungsspannung übersteigen kann.

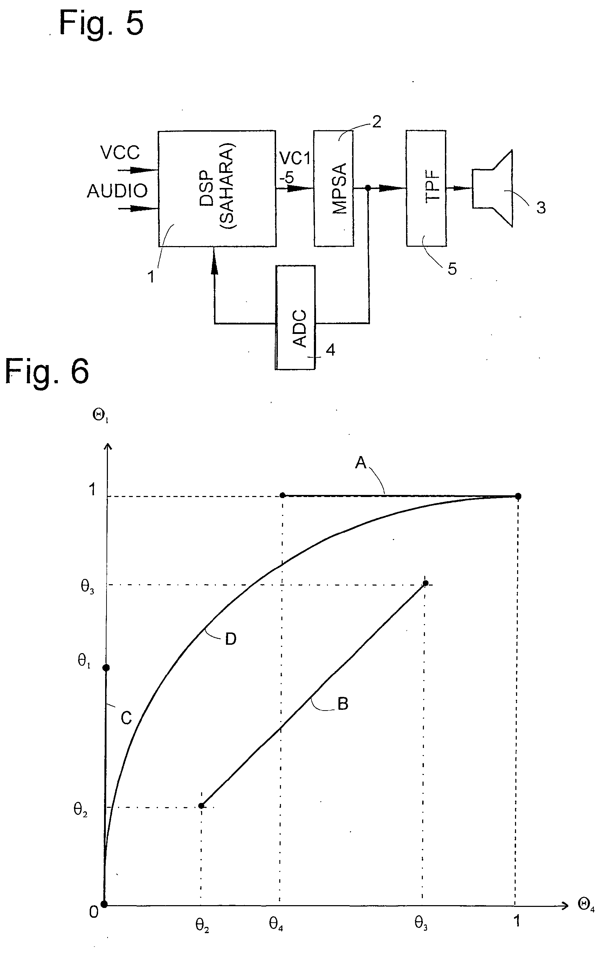

In Fig. 4 wird zwischen drei verschiedenen, den Spalten a, b, c entsprechenden Betriebsmodi des Schaltreglers zum Erzeugen einer mit der Versorgungsspannung gleichnamigen Ausgangsspannung unterschieden. Diese Modi sind in dem Diagramm der Fig. 6, das Kombinationen von Tastverhältnissen Θ₁, Θ₄ der zwei Transistoren T1, T4 zeigt, als drei Geradenstücke A, B, C dargestellt. Wenn mit diesen drei Modi eine kontinuierlich von Null an zunehmende Ausgangsspannung erzeugt werden soll, wird zunächst im Modus der Spalte a bei geschlossenem zweitem Transistor T4 das Tastverhältnis des ersten Schalters von 0 bis zu einem Wert θ₁ erhöht, an dem ein erster Grenzwert der Ausgangsspannung unterhalb der Versorgungsspannung erreicht ist (Geradenstück C) , dann wird auf den Modus der Spalte b gewechselt, in dem beide Schalter T1, T4 mit einem Tastverhältnis betrieben werden, das von einem dem ersten Grenzwert entsprechenden Anfangswert θ₂ auf einen Endwert θ₃ anwächst, der einem zweiten Grenzwert der Spannung oberhalb der Versorgungsspannung entspricht (Geradenstück B), und schließlich wird auf den Modus der Spalte a gewechselt, in dem der erste Transistor T1 ständig offen ist und das Tastverhältnis des zweiten Transistors von einem Anfangswert θ₄ bis nahe 1 erhöht wird (Geradenstück A). Alternativ hierzu können auch von 0, 1 oder Gleichheit abweichende Tastverhältnisse Θ₁, Θ₄ zugelassen werden; so kann ein gewünschter Verlauf der Ausgangsspannung z.B. auch durch Verfolgen der kontinuierlichen Trajektorie D nachgebildet werden.

Die Schaltung der Fig. 2 ist geeignet zum Aufbau eines Audioverstärkers, mit dem sich auch hochohmige Lautsprecher mit einer beträchtlichen Ausgangsleistung ansteuern lassen. Ein Blockschaltbild eines solchen Audioverstärkers ist in Figur 5 gezeigt. Es umfaßt einen digitalen Signalprozessor (DSP) 1, dem eine Versorgungsspannung VCC und ein Audiosignal AUDIO zugeführt werden. Das Audiosignal kann von vornherein digital sein oder zur Verarbeitung im digitalen Signalprozessor 1 in einem (nicht dargestellten) A/D-Wandler digitalisiert werden. Anhand jedes digitalen Audiosignalwertes berechnet der Signalprozessor 1 eine zum Ansteuern eines Lautsprechers 3 benötigte Ausgangsspannung des erfindungsgemäßen Schaltreglers 2 und führt dessen Transistoren die entsprechenden Steuerspannungen VC1 bis VC5 zu. Die Festlegung dieser Steuerspannungen bzw. der Tastverhältnisse der in den verschiedenen Modi alternierend betriebenen Transistoren kann z.B. anhand von in der Ansteuerschaltung gespeicherten Tabellen erfolgen, die diese Parameter als Funktion einer Soll-Ausgangsspannung spezifizieren. Der Lautsprecher 3 ist mit dem Ausgang des Schaltreglers 2 über ein Tiefpassfilter 5 verbunden.

Ein Analog-Digital-Wandler 4 ist an den Ausgangsanschluß des Schaltreglers 2 gekoppelt, um einen digitalisierten Wert der Ausgangsspannung an den digitalen Signalprozessor 1 zurückzuliefern. Dieser vergleicht den vom Analog-Digital-Wandler 4 gelieferten Wert mit der zuvor berechneten gewünschten Ausgangsspannung und korrigiert im Falle einer Abweichung das Tastverhältnis der im gerade benutzten Modus a, b, c oder d alternierend betriebenen Transistoren.

Es liegt auf der Hand, daß die Tastfrequenz, mit der der Signalprozessor 1 den Schaltregler 2 ansteuert, um ein Vielfaches oberhalb der oberen Grenzfrequenz des Audiosignals liegen muß, um zu gewährleisten, daß die Restwelligkeit im Ausgang des Schaltreglers, die auf das alternierende Schalten der Transistoren zurückgeht, von dem Tiefpassfilter 5 wirksam unterdrückt werden kann.

Wenn das zugeführte Audiosignal AUDIO ein digitales Signal ist, so wird für den Analog-Digital-Wandler 4 zweckmäßigerweise eine Arbeitsfrequenz gewählt, die gleich der Abtastfrequenz des Audiosignals oder ein kleines Vielfaches davon ist. Sie kann z.B. 44,1 kHz betragen. Um Verzerrungen im Ausgangssignal des Verstärkers durch die zeitdiskrete Arbeitsweise des Schaltreglers zu vermeiden, muß die Frequenz der Abtastwerte um ein Vielfaches größer sein als die Arbeitsfrequenz des Schaltreglers. Das heißt, bei der oben angenommenen Tastfrequenz von 44,1 kHz und einem Größenverhältnis der Frequenzen von ca. 10 ist eine verzerrungsarme Verstärkung von Audiosignalen im Frequenzbereich bis hin zu ca. 4 kHz möglich.

## Patentansprüche

1. Schaltregler mit einem Versorgungsspannungsanschluss (IN), einem Masseanschluss (OUT), einem induktiven Element (L), von dem eine erste Klemme über einen ersten Schalter (T1) mit dem Versorgungsspannungsanschluss (IN) verbindbar ist, einem kapazitiven Element (C), von dem eine erste Klemme mit einer zweiten Klemme des induktiven Elements (L) und eine zweite Klemme mit dem Masseanschluss (GND) verbunden ist, und mit einem Ausgangsanschluss (OUT) zum Ausgeben einer Ausgangsspannung, der mit der ersten Klemme des kapazitiven Elements (C) verbunden ist, **dadurch gekennzeichnet, dass** ein zweiter Schalter (T4) parallel zu dem kapazitiven Element (C) angeordnet ist.

2. Schaltregler nach Anspruch 1, **dadurch gekennzeichnet, dass** eine Diode (D1) bezogen auf die Versorgungsspannung in Sperrrichtung parallel zu der Reihenschaltung von induktivem und kapazitivem Element (L, C) angeordnet ist.

3. Schaltregler nach Anspruch 2, **gekennzeichnet durch** einen dritten Schalter (T2), der in Reihe mit der ersten Diode (D1) parallel zu der Reihenschaltung von induktivem und kapazitivem Element (L, C) angeordnet ist.

4. Schaltregler nach einem der vorhergehenden Ansprüche, **gekennzeichnet durch** eine Ansteuerschaltung (1) zum gleichphasigen Öffnen und Schließen des ersten und des zweiten Schalters (T1, T4).

5. Schaltregler nach Anspruch 4, **dadurch gekennzeichnet, dass** die Ansteuerschaltung (1) zum Erzeugen einer Ausgangsspannung in einem Intervall um die Versorgungsspannung den ersten und den zweiten Schalter (T1, T4) gleichphasig öffnet und schließt und zum Erzeugen einer Ausgangsspannung oberhalb dieses Intervalls den zweiten Schalter (T4) öffnet und schließt, während sie den ersten Schalter (T1) offen hält.

6. Schaltregler nach Anspruch 4 oder 5, **dadurch gekennzeichnet, dass** die Ansteuerschaltung (1) zum Erzeugen einer Ausgangsspannung in einem Intervall um die Versorgungsspannung den ersten und den zweiten Schalter (T1, T4) gleichphasig öffnet und schließt und zum Erzeugen einer Ausgangsspannung unterhalb dieses Intervalls den ersten Schalter (T1) öffnet und schließt, während sie den zweiten Schalter (T4) geschlossen hält.

7. Schaltregler nach einem der vorhergehenden Ansprüche, **gekennzeichnet durch** einen vierten Schalter (T5) zum Unterbrechen der Verbindung zwischen der zweiten Klemme des induktiven Elements (L) und der ersten Klemme des kapazitivem Elements (C) und **durch** eine zweite Diode (D3), die bezogen auf die Versorgungsspannung (Vcc) in Sperrrichtung gepolt die ersten Klemmen des induktiven und des kapazitiven Elements (L, C) verbindet.

8. Schaltregler nach Anspruch 7, **gekennzeichnet durch** einen in Reihe mit der zweiten Diode (D3) zwischen den ersten Klemmen des induktiven und des kapazitiven Elements (L, C) angeordneten fünften Schalter (T3).

9. Schaltregler nach Anspruch 8, **gekennzeichnet durch** eine Ansteuerschaltung, die zum Erzeugen einer mit der Versorgungsspannung gleichnamigen Ausgangsspannung den vierten Schalter (T5) geöffnet und den fünften Schalter (T4) geschlossen hält, und die zum Erzeugen einer mit der einer mit der Versorgungsspannung ungleichnamigen Ausgangsspannung den vierten Schalter (T5) geschlossen und den fünften Schalter (T4) geöffnet hält.

10. Schaltregler nach einem der Ansprüche 4,5, 6 oder 9, **dadurch gekennzeichnet, dass** die Ansteuerschaltung (1) als digitaler Signalprozessor ausgebildet ist.

11. Verstärker, insbesondere für ein Audiosignal, **dadurch gekennzeichnet, dass** er einen Schaltregler (2) nach einem der vorhergehenden Ansprüche aufweist, und dass das Ausgangssignal des Verstärkers von der Ausgangsspannung des Schaltreglers (2) abgeleitet ist.

12. Verstärker nach Anspruch 11, **dadurch gekennzeichnet, dass** er einen Komparator zum Vergleichen der Ausgangsspannung des Schaltreglers (2) mit einer als Funktion des Verstärkereingangssignals vorgegebenen Spannung aufweist.

13. Verstärker nach Anspruch 11 oder 12, **dadurch gekennzeichnet, dass** zwischen dem Ausgangsanschluss des Schaltreglers (2) und dem Ausgang des Verstärkers ein Tiefpassfilter (5) angeordnet ist.
